Europäisches Patentamt

European Patent Office

Office européen des brevets

(19)

(11) Numéro de publication : **0 392 944 B1**

# (12) FASCICULE DE BREVET EUROPEEN

(45) Date de publication du fascicule du brevet :
17.06.92 Bulletin 92/25

(51) Int. Cl.⁵ : **H01L 29/86, H01L 29/36**

(21) Numéro de dépôt : **90420181.1**

(22) Date de dépôt : **11.04.90**

(54) **Résistance spirale haute tension.**

(30) Priorité : **14.04.89 FR 8905280**

(43) Date de publication de la demande :
**17.10.90 Bulletin 90/42**

(45) Mention de la délivrance du brevet :
**17.06.92 Bulletin 92/25**

(84) Etats contractants désignés :
**DE FR GB IT NL**

(56) Documents cités :
**EP-A- 0 240 435**
**NEUES AUS DER TECHNIK, no. 1, 1 février**
**1973, page 2; "Doppeldiffundierter planarer**
**Halbleiterwiderstand, insbesondereEmitterwi-**
**derstand in Hf-Leistungstransistoren"**

(73) Titulaire : **SGS-THOMSON**
**MICROELECTRONICS S.A.**
**7, Avenue Galliéni**
**F-94250 Gentilly (FR)**

(72) Inventeur : **Mille, Jacques**
**18, Rue Matheron**
**F-13100 Aix en Provence (FR)**
Inventeur : **Quessada, Daniel**
**Hameau des Hermentaires**
**F-83910 Pourrieres (FR)**

(74) Mandataire : **de Beaumont, Michel**
**1bis, rue Champollion**
**F-38000 Grenoble (FR)**

EP 0 392 944 B1

Jouve, 18, rue Saint-Denis, 75001 PARIS

## Description

La présente invention concerne une résistance diffusée haute tension en forme de spirale intégrée sur un substrat semiconducteur et susceptible d'avoir une de ses extrémités connectée à un point du substrat soumis à un potentiel élevé et l'autre soumise à un potentiel faible.

Une telle résistance est décrite dans le brevet des Etats-Unis d'Amérique US-A- 4 792 840. (correspondant EP-A-240435) Cette résistance est constituée d'une région en forme de spirale d'un deuxième type de conductivité et de niveau de dopage donné formée sur une première face d'un substrat semiconducteur du premier type de conductivité et comprend une première borne liée à une première extrémité de la spirale et une deuxième borne sur la deuxième face du substrat, la deuxième extrémité de la spirale étant connectée à une zone surdopée du même type de conductivité que le substrat.

Il apparaîtra à l'homme de l'art qu'une telle résistance peut être réalisée ou bien, comme cela est décrit plus particulièrement dans le brevet américain susmentionné, avec la connexion entre une extrémité de la spirale et la face arrière du substrat assurée au niveau du centre de la spirale ou bien avec cette connexion réalisée au niveau de l'extrémité extérieure de la spirale. On choisira cette deuxième solution plus particulièrement dans le cas où la spirale entoure la puce de circuit intégré sur laquelle elle est disposée et sert en outre à la fonction d'anneaux de garde périphériques.

Toutefois, la réalisation d'une résistance spirale telle que décrite dans le brevet américain susmentionné pose des difficultés pratiques notamment en ce qui concerne la tenue en tension et l'ajustement de la valeur de la résistance.

En effet, le nombre de tours de la spirale et la distance entre tours doivent être choisis en fonction de considérations électrostatiques liées à la valeur maximale de la différence de tension susceptible d'être appliquée entre les faces avant et arrière du substrat, en tenant compte des valeurs de dopage du substrat et de la spirale. Mais, quand on considère une spirale telle qu'illustrée en figure 2 du brevet américain susmentionné, et comprenant un enroulement spiral autour d'un point central, on peut voir que le dernier tour de la spirale a une longueur beaucoup plus grande que celle des tours précédents et notamment du tour intérieur. Ainsi, la chute de tension sur le dernier tour sera beaucoup plus élevée que la chute de tension sur chacun des autres tours. Il en résulte que l'on ne peut pas, pour des spirales à enroulement central serré, dépasser une certaine valeur de tenue en tension pour des valeurs données des divers niveaux de dopage.

En outre, dans le brevet américain susmentionné, il est exposé que la résistance spirale concernée est réalisée dans le cadre d'un circuit intégré comprenant d'autres composants et notamment des transistors bipolaires ou MOS de puissance. Si l'on veut pouvoir réaliser la spirale de façon économique, il importe qu'elle soit réalisée en même temps qu'une autre étape de fabrication des circuits se trouvant sur la même plaquette de circuit intégré, c'est-à-dire que son niveau de dopage sera choisi parmi les niveaux de dopage déjà prévus dans le cadre de la fabrication du circuit intégré en question. Par exemple, dans certains circuits intégrés il n'existe que deux étapes de réalisation de dopage d'un substrat selon le type de conductivité opposé à celui du substrat, un niveau de dopage que l'on appelera faible et un niveau de dopage que l'on appelera élevé. Etant donné que l'on a vu précédemment que le nombre de tours à prévoir pour la spirale dépend de paramètres électrostatiques liés à la tension qu'elle doit être capable de supporter, pour donner à cette résistance spirale une valeur voulue prédéterminée, il faudrait pouvoir agir sur sa résistivité par unité de longueur, c'est-à-dire sur sa section ou sur son niveau de dopage. Il n'est pas économique d'agir sur le niveau de dopage ou sur la profondeur de la couche diffusée utilisée par la spirale car cela obligerait à prévoir une étape de fabrication supplémentaire et il n'est pas non plus très commode d'agir sur la largeur de la spirale car cela risquerait d'entraîner pour celle-ci un encombrement excessif.

Ainsi, un objet de la présente invention est de prévoir un perfectionnement à la réalisation de résistances spirales du type susmentionné permettant d'éviter les deux inconvénients indiqués, c'est-à-dire permettant, d'une part, d'augmenter la tenue en tension maximale d'une résistance spirale et, d'autre part, de réaliser des résistances spirales de valeurs préétablies, sans augmenter le nombre d'étapes de fabrication d'un circuit intégré.

Pour atteindre cet objet, la présente invention prévoit de réaliser une résistance spirale constituée d'une région d'un premier niveau de dopage et de rendre plus conductrice des parties localisées choisies de cette résistance, par exemple en réalisant des surdopages du même type de conductivité que celui de la spirale, en même temps que l'on réalise des zones fortement dopées de ce type de conductivité dans le circuit intégré porté par le même substrat semiconducteur, comme décrit dans les revendications.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1 représente en vue de dessus un exemple de spirale selon la présente invention ;

la figure 2 représente une vue en coupe partielle selon la ligne II-II de la figure 1 ; et

la figure 3 représente une vue de dessus partielle d'une variante de réalisation de la présente invention.

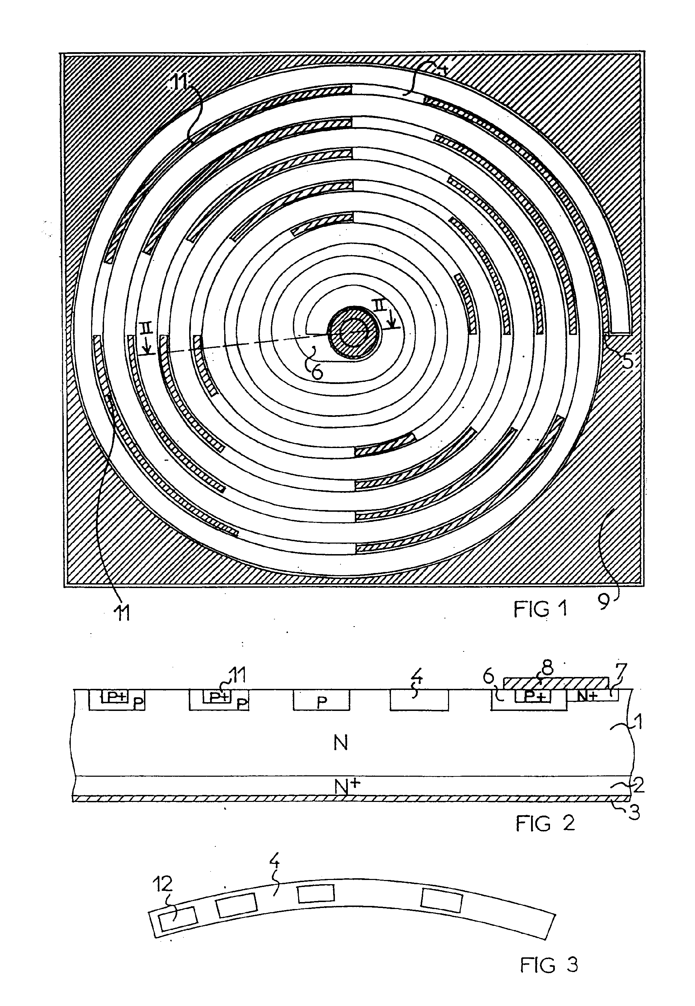

Comme le représentent la figure 1 et la vue en coupe partielle de la figure 2 correspondant à la ligne II-II de la figure 1, la présente invention prévoit une résistance spirale formée dans un substrat 1 d'un premier type de conductivité, par exemple N, dont la face arrière comprend une couche surdopée 2 de type et est revêtue d'une métallisation 3. La résistance spirale proprement dite est constituée d'une région diffusée 4 de type opposé (ici P) enroulée en forme de spirale, comprenant une première région d'extrémité 5 et une deuxième région d'extrémité 6. Une partie de l'une des régions d'extrémité, ici la région d'extrémité interne 6, est surdopée et connectée à une région surdopée 7 de type N+ du substrat par une métallisation 8. Ainsi, cette extrémité de la résistance spirale est en relation de conduction avec la métallisation de face arrière 3 du substrat. La région d'extrémité 5 est elle-même reliée à une borne non représentée sur la face avant du substrat, soit directement, soit par l'intermédiaire d'une région périphérique 9 de type P+.

Ce qui vient d'être décrit en relation avec les figures 1 et 2 correspond à l'état de la technique décrit dans le brevet américain 4 792 840.

Le perfectionnement selon la présente invention consiste à moduler la résistivité de la spirale. Dans le mode de réalisation illustré en figures 1 et 2, des zones de type P+ 11 sont disposées en des emplacements choisis de chaque tour de la spirale. Par exemple, si l'on veut que tous les tours de la spirale aient sensiblement la même résistance, on placera des régions P+ beaucoup plus allongées dans les parties périphériques que dans la partie centrale.

Dans le cadre du mode de réalisation de la figure 1, les zones P+ sont disposées selon une certaine longueur sur chaque quart de tour de spirale. Dans d'autres modes de réalisation, par exemple celui illustré en figure 3, on pourrait prévoir des zones P+ 12 ayant toujours la même configuration, des plots, mais réparties avec des densités inégales le long de chaque tour de la spirale 4.

Grâce à la présente invention, on peut obtenir que tous les tours de la spirale aient la même valeur de résistance. Ainsi, la tension appliquée entre les bornes extrêmes de la spirale pourra atteindre des valeurs allant jusqu'à plusieurs centaines, voire plus d'un millier de volts, étant donné que la même chute de tension existera entre chaque tour alors que, en l'absence de cette modulation de résistivité, la chute de tension entre deux points adjacents du dernier et de l'avant dernier-tour aurait été beaucoup plus élevée que la chute de tension entre deux points adjacents des premiers tours.

Selon un autre avantage de l'invention, même quand on n'est pas contraint par des considérations de tenue en tension d'avoir des tours de spirale de résistance globale sensiblement constante, la présente invention permet d'obtenir une valeur de résistance choisie pour l'ensemble de la spirale.

Etant donnée une spirale ayant un nombre de tours préétabli, celle-ci sera formée par une diffusion d'un type de conductivité et d'un niveau de dopage donné correspondant à celui d'une autre étape de fabrication, par exemple au caisson dans lequel est formé l'un des transistors MOS d'un couple de transistors MOS complémentaires. Les régions surdopées correspondront elles aux régions surdopées de prise de contact. Ainsi, la réalisation d'une spirale selon l'invention n'exige aucune étape de fabrication supplémentaire par rapport aux étapes classiquement utilisées pour la réalisation d'ensemble d'un circuit intégré.

Bien entendu, la présente invention est susceptible de nombreuses variantes, son aspect essentiel résidant dans la modification de la résistance de chaque tour d'une spirale en utilisant des zones de conductivité augmentée obtenues par un processus correspondant à une autre étape de fabrication du circuit intégré. Par exemple, on pourrait envisager des courts-circuits d'aluminium correspondant à des portions d'une couche d'aluminium ou autre métallisation finale. Néanmoins, ce procédé de réalisation présenterait l'inconvénient de rendre difficile l'obtention d'une valeur de résistance choisie, l'interface entre une région faiblement dopée et une couche d'aluminium étant mal définie électriquement. Par contre, on pourra prévoir de déposer une couche d'aluminium sur les régions surdopées 11 et 12 susmentionnées.

## Revendications

1. Résistance constituée d'une région spirale (4) d'un deuxième type de conductivité et de niveau de dopage donné formée sur une première face d'un substrat semiconducteur (1) du premier type de conductivité, comprenant une première borne liée à une première extrémité de la spirale et une deuxième borne (3) connectée électriquement à la deuxième face du substrat par l'intermédiaire d'une zone surdopée (2) du premier type de conductivité cette deuxième borne (3) étant en relation de conduction aved la deuxième extrémité (6) de la spirale, cette deuxième extrémité de la spirale étant surdopée du deuxième type de conductivité et connectée à une région surdopée (7) du premier type de conductivité, formée sur la première face du substrat, par une métallisation (8), caractérisé en ce que ladite région spirale (4) contient des zones plus conductrices (11, 12) qui sont formées en des emplacements choisis de la spirale.

2. Résistance selon la revendication 1, caractérisée en ce que les zones plus conductrices sont des zones du deuxième type de conductivité de niveau de dopage plus élevé que ledit niveau de dopage donné.

3. Résistance selon l'une des revendications 1 ou 2, caractérisée en ce que les étendues, ou le nombre par unité de longueur de la spirale, des zones plus conductrices (11,12) sont choisies pour que la résistance de chaque tour de la spirale soit la même que celles des autres tours.

4. Résistance selon la revendication 2, caractérisée en ce qu'elle est incorporée dans une puce de circuit intégré et en ce que ledit niveau de dopage donné et ledit niveau de dopage plus élevé correspondant à des niveaux de dopage résultant d'étapes de traitement utilisées pour d'autres éléments dudit circuit intégré.

**Patentansprüche**

1. Widerstand aus einem spiralförmigen Abschnitt (4) einer zweiten Leitfähigkeitsart mit einem gegebenen Dotierungspegel, der auf einer ersten Oberfläche eines Halbleitersubstrats (1) der ersten Leitfähigkeitsart ausgebildet ist und einen ersten und einen zweiten Anschluß (3) aufweist, wobei der erste Anschluß mit einem ersten Ende der Spirale und der zweite Anschluß (3) elektrisch über einen hochdotierten Bereich (2) der ersten Leitfähigkeitsart mit der zweiten Oberfläche des Substrats verbunden sind, dieser zweite Anschluß (3) mit dem zweiten Ende (6) der Spirale galvanisch gekoppelt ist, das zweite Ende (6) der Spirale gemäß der zweiten Leitfähigkeitsart hochdotiert und mit einem auf der ersten Oberfläche des Substrats ausgebildeten, hochdotierten Bereich (7) der ersten Leitfähigkeitsart über eine Metallisierung (8) verbunden ist, dadurch **gekennzeichnet,** daß der spiralförmige Abschnitt (4) Zonen (11, 12) höherer Leitfähigkeit aufweist, die an bestimmten Stellen der Spirale ausgebildet sind.

2. Widerstand nach Anspruch 1, dadurch **gekennzeichnet,** daß die Zonen höherer Leitfähigkeit Zonen der zweiten Leitfähigkeitsart mit einer höheren Dotierung als dem gegebenen Dotierungspegel sind.

3. Widerstand nach Anspruch 1 oder 2, dadurch **gekennzeichnet,** daß die Oberfläche, oder die Anzahl pro Längeneinheit der Spirale, der Zonen höherer Leitfähigkeit (11, 12) so gewählt ist, daß der Widerstandswert jeder Windung der Spirale gleich dem der anderen Windungen ist.

4. Widerstand nach Anspruch 2, dadurch **gekennzeichnet,** daß er in einem Baustein mit integriertem Schaltkreis eingesetzt ist, und daß der gegebene Dotierungspegel und der Pegel der höheren Dotierung Dotierungspegeln entsprechen, die sich aus den für andere Elemente des integrierten Schaltkreises eingesetzten Verarbeitungsstufen ergeben.

**Claims**

1. A resistor constituted by a spiral region (4) of a second conductivity type having a determined doping level, formed on a first surface of a semiconductor substrate (1) of a first conductivity type, comprising a first terminal connected to a first extremity of the spiral on said first surface and a second terminal (3) electrically connected to the second surface of the substrate through an overdoped region (2) of the first conductivity type as the substrate, said second terminal (2) being in conductive relationship with the second extremity (6) of the spiral, said second extremity of the spiral being overdoped according to the second conductivity type and connected with an overdoped region (7) of the first conductivity type, formed on the first face of the substrate, through a metallization (8), characterized in that said spiral region (4) contains more conductive areas (11, 12) which are formed at determined places of the spiral.

2. A resistor according to claim 1, characterized in that said more conductive areas are of the second conductivity type having a doping level higher than said determined doping level.

3. resistor according to claim 1 or 2, characterized in that the surfaces, or the number per length unit of the spiral, of the more conductive areas (11, 12) are chosen so that the resistance of each spiral turn is the same as the resistance of the other turns.

4. A resistor according to claim 2, characterized in that it is incorporated in an integrated circuit chip and said determined doping level and said higher doping level correspond to doping levels used for other elements of said integrated circuit.

FIG 1

FIG 2

FIG 3